Europäisches Patentamt

European Patent Office

Office européen des brevets

(19)

(11) Veröffentlichungsnummer: **0 034 208**

**A1**

(12) EUROPÄISCHE PATENTANMELDUNG

(21) Anmeldenummer: **80107525.0**

(22) Anmeldetag: **02.12.80**

(51) Int. Cl.³: **H 01 L 23/10**
**H 01 L 23/30, H 01 L 21/56**
**H 01 L 29/86**

(30) Priorität: **13.02.80 DE 8003774 U**

(43) Veröffentlichungstag der Anmeldung:
**26.08.81 Patentblatt 81/34**

(84) Benannte Vertragsstaaten:
**AT CH DE FR GB IT LI NL SE**

(71) Anmelder: **ROBERT BOSCH GMBH**
**Postfach 50**
**D-7000 Stuttgart 1(DE)**

(72) Erfinder: **Heyke, Klaus, Dr. Dipl.-Ing.**
**Bodächerstrasse 23**
**D-7410 Reutlingen(DE)**

(72) Erfinder: **Mertz, Klaus, Dr. Dipl.-Chem.-**
**Reutestrasse 23/2**
**D-7401 Pliezhausen 3(DE)**

(54) **Leistungsdiode.**

(57) Es wird eine Leistungsdiode mit zwei bolzenartigen Anschlußleitern (1, 2) vorgeschlagen. Zwischen den beiden Anschlußleitern (1, 2) ist ein scheibenförmiger Halbleiterkörper (3) festgelötet. Eine Kunstharzmasse (5) überdeckt Teile der beiden Anschlußleiter (1,2) und den Rand des Halbleiterkörpers (3). Die Kunstharzmasse (5) ist in eine Kunststoffhülse (6) eingegossen, die mit einem Bodenteil (6a) dicht an einem (2) der beiden Anschlußleiter (1,2) anliegt. Vorsprünge (1a, 2a) der beiden bolzenartigen Anschlußleiter (1,2) ragen in die Kunstharzmasse (5) hinein.

EP 0 034 208 A1

Croydon Printing Company Ltd.

R. 6053
31.1.1980 Fb/Sm

Robert Bosch GmbH, 7000 Stuttgart 1

Leistungsdiode

Stand der Technik

Die Erfindung betrifft eine Leistungsdiode nach der Gattung des Hauptanspruchs. Leistungsdioden dieser Art sind aus der AT-PS 239 310 bekannt. Bei diesen Leistungsdioden wird die Kunstharzmasse durch Umpressen hergestellt und schließt die Diode nach außen ab.

Vorteile der Erfindung

Die erfindungsgemäße Leistungsdiode mit den kennzeichnenden Merkmalen des Hauptanspruchs hat demgegenüber den Vorteil, daß die Kunstharzmasse durch Vergießen hergestellt werden kann. Dies bewirkt eine Kostenreduktion und eine Verbesserung der Dichtigkeit der Diode und erleichtert die Fertigung.

Zeichnung

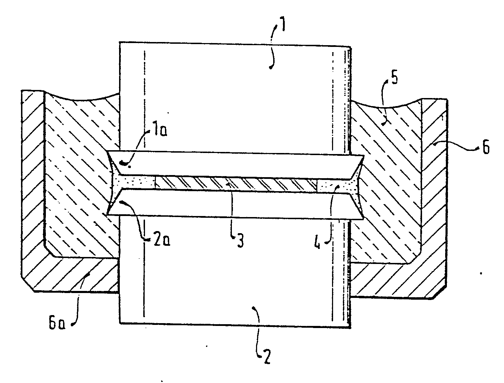

Ein Ausführungsbeispiel der erfindungsgemäßen Leistungsdiode ist in der Zeichnung dargestellt und in der nachfolgenden Beschreibung näher erläutert. Die einzige Figur zeigt dieses Ausführungsbeispiel im Schnitt.

...

R.

Fb/Sm

## Beschreibung des Ausführungsbeispiels

Bei der in der einzigen Figur dargestellten Leistungsdiode ist mit 1 ein erster bolzenartiger Anschlußleiter und mit 2 ein zweiter bolzenartiger Anschlußleiter bezeichnet. Die beiden Teile 1 und 2 sind rotationssymmetrische vernickelte Kupferteile. Zwischen
den beiden Anschlußleitern 1 und 2 ist ein scheibenförmiger Halbleiterkörper 3 festgelötet. Der Rand
des Halbleiterkörpers 3 ist mit einem Schutzlack 4
bedeckt. Ferner ist eine Kunstharzmasse 5 vorgesehen,
die Teile der Anschlußleiter 1 und 2 und den Rand
des Halbleiterkörpers3 überdeckt. Die Kunstharzmasse
5 ist in eine Kunststoffhülse 6 eingegossen, die
mit einem Bodenteil 6a dicht an dem Anschlußleiter 2
anliegt. Vorsprünge 1a, 2a der beiden Anschlußleiter
1, 2 ragen in die Kunstharzmasse 5 hinein.

R. C G S T
31.1.1980 Fb/Sm

Robert Bosch GmbH, 7000 Stuttgart 1

Ansprüche

1. Leistungsdiode mit zwei bolzenartigen Anschlußleitern (1, 2), einem scheibenförmigen Halbleiterkörper
(3), der zwischen den Anschlußleitern (1, 2) festgelötet ist, und mit einer Kunstharzmasse (5), die Teile
der Anschlußleiter (1, 2) und den Rand des Halbleiterkörpers (3) überdeckt, dadurch gekennzeichnet, daß
die Kunstharzmasse (5) eine dicht an einem (2) der
Anschlußleiter (1, 2) anliegende Kunststoffhülse (6)
ausfüllt.

2. Leistungsdiode nach Anspruch 1, dadurch gekennzeichnet, daß Vorsprünge (1a, 2a) der beiden bolzenartigen Anschlußleiter (1, 2) in die Kunstharzmasse
(5) hineinragen.

Europäisches
Patentamt

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| X | US - A - 2 964 831 (J.D. PETERSON) <br> * Spalte 1, Zeilen 36 bis 45; <br> Spalte 1, Zeile 72 bis Spalte 2, <br> Zeile 2; Fig. 1 * <br> -- | 1 |
| D,A | AT - B - 239 310 (CKD PRAHA) <br> -- | |
| A | GB - A - 1 192 341 (WESTINGHOUSE ELECTRIC) <br> -- | |
| A | DE - A1 - 2 727 178 (R. BOSCH GMBH) <br> * Seite 7, letzter Absatz; Fig. 3 * <br> ---- | |

**KLASSIFIKATION DER ANMELDUNG (Int. Cl.³)**

H 01 L    23/10
H 01 L    23/30
H 01 L    21/56
H 01 L    29/86

**RECHERCHIERTE SACHGEBIETE (Int. Cl.³)**

H 01 L    21/50
H 01 L    23/02
H 01 L    23/24
H 01 L    23/28

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Berlin | 30-04-1981 | GIBBS |

EPA form 1503.1  06.78